(19) Europäisches Patentamt
European Patent Office
Office européen des brevets

(11) Publication number: **0 324 486 A2**

# (12) EUROPEAN PATENT APPLICATION

(21) Application number: 89100506.8

(51) Int. Cl.[4]: H03K 17/14

(22) Date of filing: 13.01.89

(30) Priority: 15.01.88 CS 281/88

(43) Date of publication of application: 19.07.89 Bulletin 89/29

(84) Designated Contracting States: AT CH DE FR GR IT LI

(71) Applicant: CKD PRAHA, kombinát
U Kolbenky 159
Prag 9(CS)

(72) Inventor: Kokes, Antonin, RNDr CSc
Praha 6
Slunná 27(CS)
Inventor: Popov, Petr, Dipl.-Ing.
Praha 4
Sládkovicova 1232(CS)

(74) Representative: Patentanwälte Beetz sen. - Beetz jun. Timpe - Siegfried - Schmitt-Fumian- Mayr
Steinsdorfstrasse 10
D-8000 München 22(DE)

## (54) Circuit arrangement for compensation of the tripping time of an electric current switch.

(57) Circuit arrangement for compensation of the disconnecting time of an electric current switch provided with a detector (9) of the end of the disconnection time comprising means (3, 4) controlling the time interval for closing the electric switch (5) in order to maintain a reliable and most effective operation of an inverted rectifier.

6
8
7
1
2
3
4
5
9

FIG. 1

EP 0 324 486 A2

Xerox Copy Centre

# CIRCUIT ARRANGEMENT FOR COMPENSATION OF THE TRIPPING TIME OF AN ELECTRIC CURRENT SWITCH

The invention relates to a circuit arrangement for compensation of the tripping time of electric current.

The application of switches for high power current at bridge connections of inverted rectifiers requires an exact maintenance of the switching time. As some elements of inverted rectifiers, for instance transistors have a mutually different tripping time-length which is in addition varying due to the tripping conditions, difficulties arise which limit their application in similar circuit arrangements. This drawback can be partly reduced by selection of cooperating elements applied in these bridge circuits, however, the principal drawback remains, so that considerable time intervals are necessary between individual cycles of inverted rectifiers, reducing thereby their maximum output.

It is the object of the present invention to provide a circuit arrangement which overcomes to a high degree said drawbacks, and which can achieve the exact maintenance of the switching time intervals.

This object is accomplished with a circuit arrangement as claimed in claim 1.

Dependent claims are directed on features of preferred embodiments of the circuit arrangement according to the invention.

An advantage of the circuit arrangement according to the present invention is that the really required length of the closing time-interval of the electric switch is achieved even in cases where the tripping time is varying.

The invention will be explained in more detail by the description of the preferred embodiments together with the drawings, in which show:

Fig. 1 a block wiring diagram and

Fig. 2 a block wiring diagram with a concrete example of an arrangement of the switch and of a detector of the end of the tripping time.

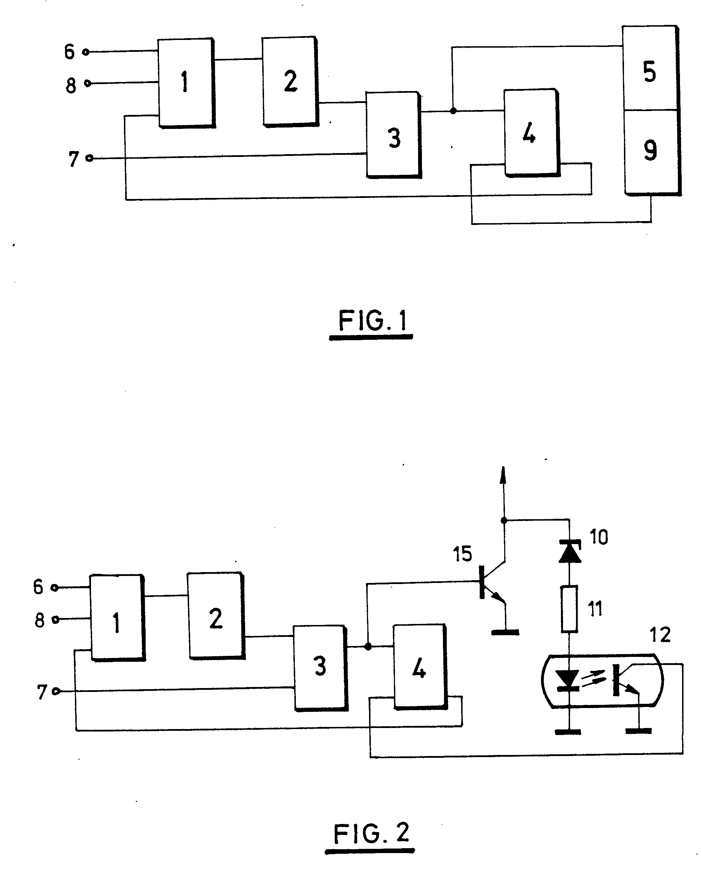

With reference to Fig. 1 an electric switch 5 provided with a detector 9 of the end of the tripping time are shown, which switch 5 is controlled by the output of a first flip-flop circuit 3, the first input of which is connected with the output of a counter 2. The input of the counter 2 is connected to the output of a gate 1. The first input 6 of said gate 1 is connected to the output of a generator of time timing-signals (not shown in the drawing). The second input of the first flip-flop circuit 3 represents a starting input 7 for closing of the switch 5 of electric current. The third input 8 of the gate 1 is connected to the output of a circuit for indication of the start of the measurement of the time of closing of the switch 5.

Fig. 2 shows an example of a circuit arrangement according to this invention where as an electric switch 5 a bipolar transistor 15 is applied. The detector 9 of the end of the closing time interval is in this case realized by means of an optoelectric connecting element 12, the inlet of which is connected by way of a Zener diode 10 and of a resistor 11 between the collector and the emitter of the transistor 15.

By supplying a signal to the starting input 7, the first flip-flop circuit 3 is triggered, closing the electric switch 5 and simultaneously triggering the second flip-flop circuit 4 which releases lthe counting of time pulses. After the prior determined condition of the counter 2 has been achieved, its output signal triggers back the first flip-flop circuit 3, which releases the order for disconnection of the electric switch 5. The second flip-flop circuit 4 remains triggered and enables the further counting of time pulses by the counter 2. Only thereafter the output signal of the detector 9 of the end of the disconnection time triggers back the second flip-flop circuit 4, the output of which stops by means of the gate 1 the counting of time pulses by the counter 2 at a value, corresponding to the disconnection time of the switch 5.

The measuring of the closing time in the course of the following cycle is reduced for the number of time pulses corresponding to the disconnection time during the preceding cycle, so that the order for disconnection of the switch 5 of electric current is released with an advance corresponding to its disconnection time and the real disconnection time has thereafter its required length.

## Claims

1. Circuit arrangement for compensation of the disconnection time of an electric current switch provided with a detector (9) of the end of the disconnection time, **characterized in** that the control input of the electric current switch (5) provided with a detector (9) of the end of the disconnection time is connected to the output of a first flip-flop circuit (3), the first input of which being connected to the output of a counter (2), the input of which being connected with the output of a gate (1), the second input of which gate (1) being connected to the output of a second flip-flop circuit (4), the first input of which being connected to the output of the first flip-flop circuit (3) while its second input is connected with the output of the detector (9) of the end of the disconnection time, whereby the second input of the first flip-flop circuit (3) represents the starting inlet (7) for closing the switch (5) of electric current and the first input (6) of the gate (1) is connected with the output of the time-pulse-generator.

2. Circuit arrangement according to claim 1, characterized in that a third input (8) of the gate (1) is connected to the output of a circuit indicating the start of measuring of closing of the switch.

6
8
7
1
2
3
4
5
9

FIG. 1

6
8
7
1
2
3
4
15
10
11
12

FIG. 2